# EUROPEAN PATENT APPLICATION

(11) **EP 3 038 181 A1**
(43) Date of publication of application: **29.06.2016**
(21) Application number: 14199911.0
(22) Date of filing: 22.12.2014
(51) Int. Cl.: H01L 51/54, C07D 219/00, H01L 51/50, C09B 15/00

(54) **ORGANIC ELECTRONIC DEVICES COMPRISING ACRIDINE DERIVATIVES IN AN EMISSIVE LAYER FREE OF HEAVY ATOM COMPOUNDS**

(71) Applicant: Solvay SA, 1120 Bruxelles (BE)
(72) Inventor: Bascour, Dominique, 1390 Grez-Doiceau (BE); Maunoury, Jonathan, 1030 Brussels (BE)
(74) Representative: Dr. Langfinger & Partner

(57) **Abstract**

Organic electronic device comprising an anode, a cathode and at least one emissive layer free of compounds of heavy atoms having an atomic number exceeding 40 comprising a compound of formula (1)
wherein R₁, is hydrogen, a C₁-C₁₈ alkyl group, a C₅-C₃₀ aryl group or a C₄-C₃₀ heteroaryl group,
R₂ and R₃, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence, are a C₁-C₁₈ alkyl group, a C₅-C₃₀ aryl group or a C₄-C₃₀ heteroaryl group, which may form together a condensed ring system,
R₄ and R₅, which may be the same or different at each occurrence, are hydrogen, a C₁-C₁₈ alkyl group, a C₅-C₃₀ aryl group or a C₄-C₃₀ heteroaryl group, or R₄ and R₅ may form together a substituted or unsubstituted C₅-C₄₀ hydrocarbyl or C₃-C₄₀ heterohydrocarbyl ring system with the exception of a fluorenyl ring system, and R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4),
and m and n, which may be the same or different, represent an integer of from 0 to 3.

## Description

The present invention relates to organic electronic devices comprising emissive layers free of transition metal compounds.

Organic light-emitting diodes (OLEDs) exploit the property of materials of emitting light when they are excited by electrical current. OLEDs are of particular interest in this regard as an alternative to cathode ray tubes and to liquid-crystal displays for producing flat visual display units.

Due to the compact design and the intrinsically low power consumption compared to classical lighting devices, devices comprising OLEDs are suitable especially for mobile applications, for example for applications in mobile phones, lap-tops, digital cameras, and for illumination purposes.

The basic principles of the way in which OLEDs work and suitable structures (layers) of OLEDs are known to those skilled in the art.

Organic electronic devise emitting light, in particular organic light emitting diodes comprise an anode, a cathode and at least one layer between these electrodes emitting light upon electrical excitation by applying a voltage.

The electrical excitation leads to the formation of both singlet and triplet states. In the electroluminiscence process the population of excited states occurs via a recombination of negatively charged electrons and positively charged holes, forming excitons in the emissive layer in a respective device. Both electrons and holes have spins and four different spin combinations are possible. According to quantum mechanics one combination of antiparallel spins, giving a singlet and three combinations of parallel spins, giving a triplet, occur. Thus, 25% of the excitons represent singlets and 75% represent triplets.

According to the spin selection rule an electronic transaction takes place with no change the total electron spin, which means that transitions between electronic states of the same spin multiplicity (singlet to singlet, triplet to triplet) are allowed while transitions between electronic states of different spin multiplicity (singlet to triplet and triplet to singlet) are formally forbidden or, more exactly, kinetically unfavorable. Due to the fact that the ground state of most organic molecules is a singlet state, these compounds only emit light from excited singlet states. Thie phenomenon is known as fluorescence and usually quite efficient. Emission from triplet states (which, as stated above, constitute 75 % of the excitons formed), known as phosphorescence, is spin-forbidden and cannot compete with non-radiative quenching (which does not contribute to the light emission).

In short, 75% of the applied electrical energy in fluorescent organic light emitting devices is basically spent for heating-up the device.

The aforementioned problem of spin statistics can be overcome by making use of emitters with enhanced spin-orbit coupling (an interaction between an electron's spin and orbital magnetic moments) induced by heavy metal atoms. Spin-orbit coupling essentially mixes singlet and triplet states which allows transition between them to a certain extent.

Heavy atoms, preferably with an atomic number exceeding 40 and in particular transition metals are known to increase spin orbit coupling and thus organic light emitting devices have been developed making use of emitters based on transition metal compounds, in particular based on iridium and platinum and have been described in numerous publications.

While the internal quantum efficiency compared to devices using fluorescence based on singlet-singlet transitions only can be boosted using this approach (and can reach values of close to 100%, i.e. four times the efficiency of devices based on fluorescence from singlet states only), devices of this type have a number of drawbacks.

The only phosphorescent materials which have been found to be feasible until today are iridium or platinum complexes which leads to high costs and, especially for Ir compounds may lead to a supply problem in the future as this metal is not available in abundance.

Moreover, until today suitable phosphorescent emitters emitting blue light still represent an unsolved need because of the intrinsic wider bandgap of these materials. Deep-blue phosphorescent emission, stable over a long period of time has not been satisfactorily achieved. In commercial applications the devices for blue light still rely mainly on mere fluorescence and thus waste approximately 75% of the electrical energy introduced.

Furthermore, phosphorescent organic light emitting diodes suffer from a marked efficiency roll-of at increasing current densities.

In the recent past a novel approach to light generation in organic light emitting diodes has been developed which is based on the thermally activated up-conversion of triplet into singlet states without using phosphorescent materials. The concept is based on the repopulation of excited singlet states by up-conversion of excited triplet states through thermal activation. The fluorescence emission from such excited singlet states is called thermally activated delayed fluorescence (hereinafter referred to as TADF) or hyperfluorescence. The emission in such devices thus does not occur from the lowest triplet state as in phosphorescent devices but results form the fluorescence of the energetically higher lying singlet state, which is also often referred to as "singlet harvesting". Triplet excitons up-convert to singlet excitons through a process known as reverse intersystem crossing (RISC) in such devices.

RISC is a quantum-mechanical phenomenon and works better the smaller the energy difference between the lowest excited singlet state and the lowest excited triplet state is.

Devices based on TADF have been described in the literature.

In EP A 2 511 360 organic light emitting materials which emit fluorescence as well as delayed fluorescence are described which have the formula 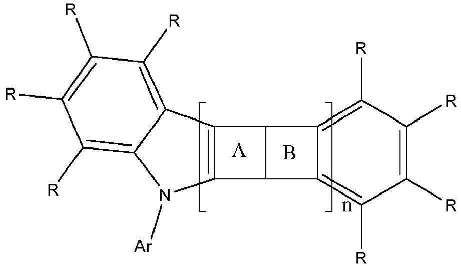 are described, wherein ring A has the structure 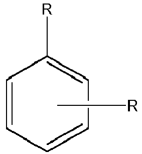 and ring B has the structure

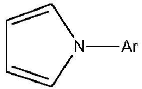

In EP A 2733761 delayed fluorescence materials having the general formula 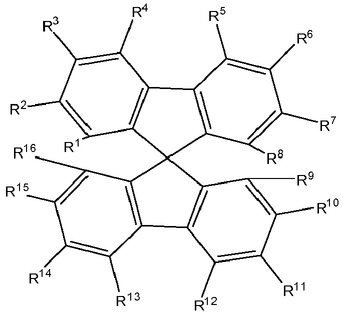 are described, wherein at least one of R₁ to R₈ is an electron-donating group and at least one of R₉ to R₁₆ is an electron-withdrawing group.

In EP A 2733762 an organic electroluminiscent element is described which comprises an anode, a cathode and at least one emitting layer therebetween which comprises a spiro-acridine compound of formula 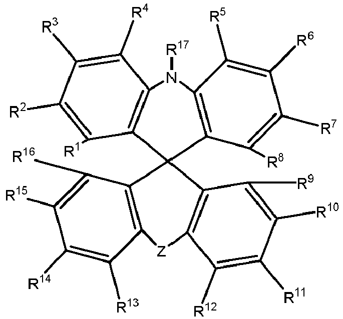 wherein at least one of R₁ to R₈ and R₁₇ is an electron donating group and at least one of R₉ to R₁₆ is an electron-withdrawing group if Z represents a single chemical bond.

EP A 2808323 describes compounds having a central triazine ring having three substituents at the carbon atoms of said ring, at least one of which has the formula

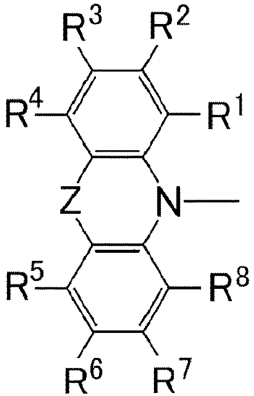

Preferably Z is a nitrogen atom, an oxygen atom, a sulfur atom or a carbonyl group.

In US A 2014/0145151 novel compounds exhibiting delayed fluorescence are disclosed which contain benzothiophene or benzofurane groups fused to a carbazole moiety.

EP A 2 787 549 discloses compounds comprising a combination of a triazine or pyrimidine ring and a carbazole group, which compounds emit delayed fluorescent light. These compounds have the general formula 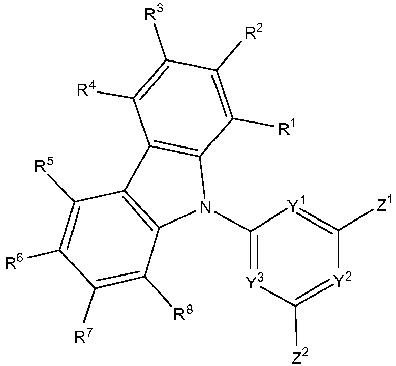 where Y is preferably a nitrogen atom.

There still exists the need for the development of organic electronic devices based on delayed fluorescence, in particular TADF, having a high quantum external efficiency as well as a good long term stability.

It was an object of the present invention to provide organic electronic devices which exhibit electroluminiscence based on delayed fluorescence, in particular TADF.

This object has been achieved with the organic electronic device in accordance with claim 1.

Preferred embodiments of the present invention are set forth in the dependent claims and the detailed specification hereinafter.

The organic electronic devices in accordance with the present invention comprise an anode and a cathode and at least one emissive layer comprising an acridine compound of general formula (1) and which emissive layer is free of compounds comprising a heavy atom having an atomic number exceeding 40.

The anode has the function of injecting holes towards the emissive layer. Preferred materials for the anode have a high work function, preferably above 4 eV. Metals such as e.g. aluminum, gold, silver, nickel, palladium or platinum), metal oxides such as e.g. indium oxide, tin oxide, zinc oxide, mixed oxides of indium and tin or of indium and zinc, halised such as e.g. copper halides or carbon black may be mentioned as inorganic anode materials. Electroconductive polymers such as e.g. polyaniline, polypyrrole or poly-3-methylthiphene may be mentioned as examples for organic anode materials.

If the emitted light is emitted through the anode side of the device, a material with a high transmission for the transmitted light is preferred.

Indium-tin oxides (ITO) or indium-zinc oxides (IZO) have shown advantages in a number of cases.

The skilled person will select the best suitable anode material based on the specific application situation and using his professional experience in 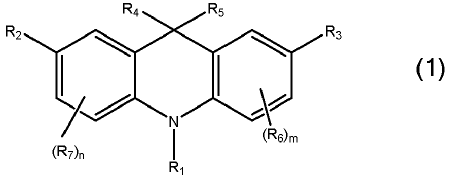 this regard so that no further details need to be given here.

The cathode serves the function of injecting electrons towards the emissive layer.

Preferred cathode materials are materials having a low work function, preferably below 4 eV. Metals such as e.g. tin, magnesium, indium, calcium or metal alloys such as aluminum-lithium alloys, magnesium-silver alloys or magnesium-indium alloys may be mentioned. If the emitted light is taken out through the cathode side, a material with a high transmission for the emitted light is preferred.

The devices in accordance with the present invention comprise an emissive layer between the cathode and the anode which comprises a compound showing delayed fluorescence and which compound is represented by general formula (1):
wherein R₁, is hydrogen, a C₁-C₁₈ alkyl group, a C₅-C₃₀ aryl group or a C₄-C₃₀ heteroaryl group,
R₂ and R₃, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence, are a C₁-C₁₈ alkyl group, a C₅-C₃₀ aryl group or a C₄-C₃₀ heteroaryl group, which may form together a condensed ring system,
R₄ and R₅, which may be the same or different at each occurrence, are hydrogen, a C₁-C₁₈ alkyl group, a C₅-C₃₀ aryl group or a C₄-C₃₀ heteroaryl group, or R₄ and R₅ may form together a substituted (with alkyl groups, aryl groups or heteroaryl groups as herein defined) or unsubstituted C₅-C₄₀ hydrocarbyl or C₃-C₄₀ heterohydrocarbyl ring system with the exception of a fluorenyl ring system,
R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4), and m and n, which may be the same or different, represent an integer of from 0 to 3.

In accordance with a first preferred embodiment of the present invention the compounds of formula (1) have a small energy gap ΔEₛₜ between the excited singlet state S1 and the excited triplet state T1 of at most 0.5, preferably at most 0.3 and even more preferably at most 0.1 eV. This facilitates reversed intersystem crossing and thus improves the quantum efficiency of the delayed fluorescence.

In accordance with a second preferred embodiment at least one of R₁, R₂, R₃, R₆ (if present) and R₇ (if present) is an electron withdrawing group, i.e. a group which exhibits the property of withdrawing an electron from the ring to which the respective substituent is bound. The electron withdrawing group may be an aromatic group, a heteroaromatic group, an aliphatic group, an inorganic group or a composite group formed of two or more of these groups. Just by way of example nitro, cyano, halogen, perfluoroalkyl groups having preferably of from 1 to 6 carbon atoms (in particular trifluoromethyl), sulfonyl, heterocyclic structures comprising a nitrogen or a sulfur atom such as e.g. oxadiazolyl, benzothiadiazoly, tetrazolyl, thiazolyl or imidazolyl and phosphine-oxide structures comprising groups may be mentioned here. Also aromatic groups bearing substituents such as halogen or cyano have been found to lead to good results. The skilled person, based on his professional knowledge will select an appropriate electron-withdrawing group based on the specific structure of the acridine structural element.

Further suitable electron withdrawing groups are disclosed in EP A 2 733 762, paragraphs 0028 to 0031 to which reference is made here for further details.

The electron withdrawing group preferably have a value for σp in the Hammett equation of at least 0.02, preferably of at least 0.20 and even more preferably of at least 0.5.

In accordance with another preferred embodiment of the present invention, at least one of R₂ and R₃, which may be the same or different, represents a group of formula (2), 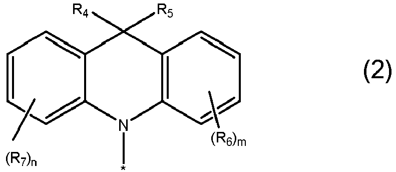 wherein
R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4), and m and n, which may be the same or different, represent an integer of from 0 to 3.

Preferred acridine compounds of formula (1) are represented by general formula (3) 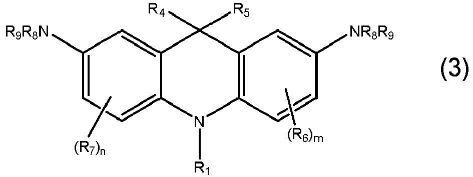 wherein R₁ and R₄ to R₉ are as defined above.

Acridine derivatives of formula (3) wherein both groups NR₈R₉, which may be the same or different, are represented by formula (2) are a further preferred embodiment of the present invention.

Acridine derivatives wherein n and m are 0 represent a further preferred group of compounds in accordance with the present invention.

In accordance with another preferred embodiment, at least one of R₂ and R₃ is represented by formula (4) 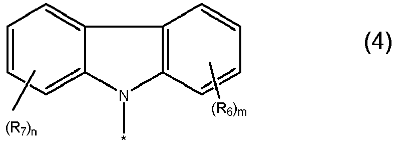 wherein R₆, R₇, m and n have the meaning as defined above.

In other preferred embodiments, R₄ and R₅ are preferably an alkyl group.

In still further preferred embodiments, R₁ is an aryl group which may be substituted or unsubstituted. As an example for an aryl substituent which has given advantageous result is certain cases substituted or unsubstituted 9,9'-spirobifluorenyl (SBF) may be mentioned here:

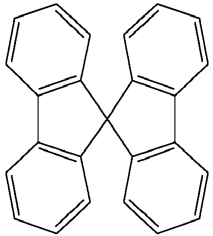

Exemplary substituents for the SBF core are C₁-C₁₈ alkyl groups, C₅-C₃₀ aryl groups or C₄-C₃₀ heteroaryl groups or groups NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4).

The term C₁-C₁₈ alkyl group, as used herein, denotes a linear, branched or cyclic group comprising 1 to 18 carbon atoms with hydrogen atoms as substituents. Linear or branched alkyl groups having 1 to 12, in particular 1 to 8 carbon atoms are preferred. Linear alkyl groups having 1 to 6 and especially 1 to 4 carbon atoms such as methyl, ethyl, n-propyl, n-butyl, n-pentyl and n-hexyl are especially preferred.

Representative examples of branched alkyl groups with 1 to 8 carbon atoms are i-propyl, i- and t-butyl and the isomeric branched methyl-or ethyl-substituted pentyl- or hexyl derivatives like e.g. 2-methylpentyl, 3-methylpentyl, 2-ethylhexyl, 3-ethylhexyl or 4-ethylhexyl to mention only a few typical representatives.

The term C₅-C₃₀ aryl group, for the purposes of the present invention denotes groups having at least one 5 to 7 membered aromatic ring with (4n+2) *π* electrons in accordance with the so called Hückel rule. Two or more aromatic rings may be annealed or fused or may be connected through a bond or an alkylene group with each other.

Representative aryl groups are thus phenyl, biphenyl, naphthyl or anthracenyl and 9,9'-spirobifluorenyl referred to above.

The aromatic rings in the aryl groups may be un-substituted or substituted by substituents selected from the group consisting of halogen, alkyl, alkoxy, amino, cyano, alkenyl, alkynyl, arylalkyl, aryl and heteroaryl groups.

Particularly preferred aryl groups are C₆-C₁₄ aryl groups like phenyl, biphenyl naphthyl and anthracenyl, which may be substituted or unsubstituted and in some cases substituted or unsubstituted phenyl, in particular unsubstituted phenyl have shown advantageous results.

The term C₄-C₃₀ heteroaryl group, when used herein, denotes a group having an aromatic ring comprising at least one heteroatom, which may be substituted or unsubstituted as described above for the aryl groups.

Preferred heteroaryl groups are heteroaryl rings containing at least one donor nitrogen atom. Said rings may be un-substituted or substituted by substituents selected from the group consisting of halogen, alkyl, alkoxy, amino, cyano, alkenyl, alkynyl, arylalkyl, aryl and heteroaryl group and/or may form an annealed ring system with other rings selected from cycloalkyl, aryl and heteroaryl rings. Heteroaryl substituents may be preferably un-substituted or substituted carbazolyl or un-substituted or substituted dibenzofuranyl.

More particularly heteroaryl groups are derived from the heteroarenes group consisting of 2H-pyrrole, 3H-pyrrole, 1 H-imidazole, 2H-imidazole, 4H-imidazole,1H-1,2,3-triazole, 2H-1,2,3-triazole, 1H-1,2,4-triazole, 1H-pyrazole, 1H-1,2,3,4-tetrazole, imidazol-2-ylidene, oxazole, isoxazole, thiazole, isothiazole, 1,2,3-oxadiazole, 1,2,5-oxadiazole, 1,2,3- thiadiazole and 1,2,5-thiadazole rings.

Nitrogen containing heteroaryl groups are preferably derived from the heteroarenes shown below 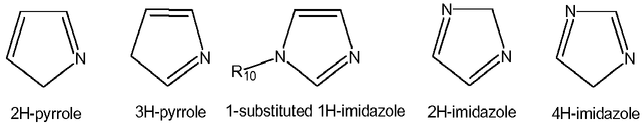 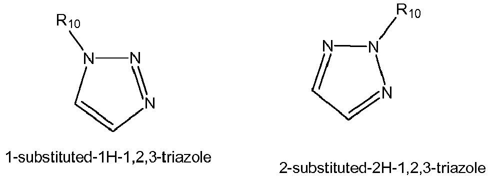 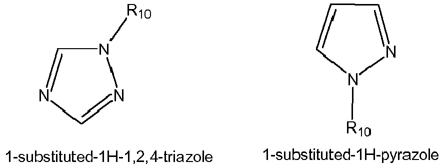 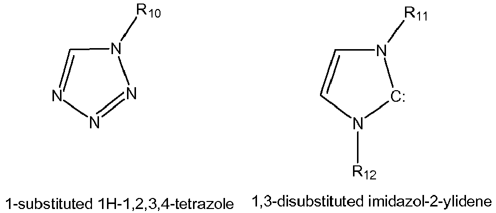 wherein R₁₀, R₁₁ and R₁₂ may be selected from a broad variety of substituents such as alkyl, alkenyl, alkynyl, arylalkyl, aryl and heteroaryl groups.

Particularly preferred acridine compounds in accordance with the present invention are the compounds of formula (1) wherein R₄ and R₅ represent a C₁-C₄ alkyl group, especially a methyl group and R₁ represents a C₆-C₁₄ aryl group, particularly preferred a phenyl group, which may be substituted or unsubstituted.

The acridine compounds in accordance with the present invention may be obtained in accordance with synthetic methods which are known per se and of which the skilled person is aware.

A preferred process for the manufacture of the compounds in accordance with the present invention is described hereinafter for an exemplary compound of formula (1); the skilled person will modify the starting materials and reactants appropriately to synthesize other compounds in accordance with the present invention, i.e. the process described is just exemplary show for specific compounds but is generally applicable.

The starting material is an acridine compound comprising substituents R₄ and R₅ as described hereinbefore and in the scheme below both R₄ and R₅ are methyl.

In a first reaction step, the hydrogen atom at the acridine nitrogen is replaced by the desired substituent R₁, in the scheme exemplified for R₁ being phenyl. This is achieved by reacting the acridine compound with a compound R₁-Hal, in particular R₁-Br as shown in the scheme in the presence of suitable catalysts and in a suitable solvent. Just by way of example toluene may be used as a solvent, and a combination of Pd(dba)₂ (Bis(dibenzylideneacetone) palladium(0)), P(t-bu)₃ (tris tert. butyl phosphine) and sodium tert. butanoate may be used as catalyst system. The skilled person is aware of this type of reaction and will appropriately select other catalyst systems or solvents as needed for the manufacture of the compounds in accordance with the present invention so that no further details concerning the reaction components need to be given here.

The first reaction step as shown below is usually carried out under inert atmosphere conditions, i.e. with the exclusion of oxygen and the reaction mixture after adding all components is heated to a temperature in the range of from 70 to 150°C, preferably of from 90 to 130°C to start the reaction. In case of toluene as solvent, the reaction may be carried out at reflux. The reaction time is usually in the range of from 6 to 48h, preferably of from 9 to 36 hours, depending on the reactants used in the specific case.

After complete conversion the reaction mixture is preferably filtered (e.g. through a celite pad) and the solvent is removed under vacuum. The purification may be carried out by chromatography, in particular flash chromatography. The desired product, bearing the substituent R₁ at the acridine nitrogen atom is usually obtained in high yields exceeding 50, in many cases exceeding seventy and in many cases even exceeding 90 %.

The reaction scheme of the first reaction step is shown below:

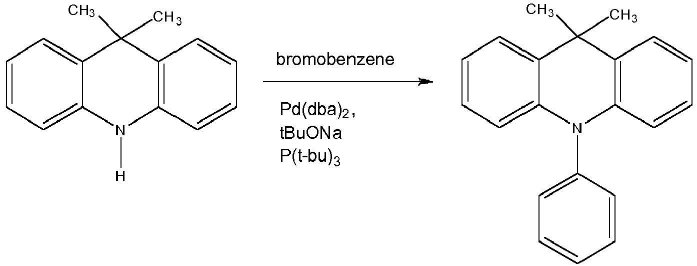

In the second step, the phenyl rings of the acridine core are brominated to create a intermediate to which the substituents R₂ and R₃ are attached in the final step.

Again, respective processes are known to the skilled person and will be selected in accordance to the needs of a specific final product, so that no further details need to be given here.

Just by way of example N-bromo succinimide may be mentioned as common brominating agent which may be used together with a suitable catalyst, e.g. Fe(III)chloride. The reaction temperature with this system is usually in the range of from 0 to 70°C, preferably of from 10 to 50°C and even more preferably around room temperature (20 to 30°C). The reaction time is usually in the range of from 6 to 96 h, preferably of from 12 to 60 hours and even more preferably in the range of from 18 to 48 h at room temperature. The skilled person will adopt the reaction conditions dependent on the starting material and the bromination agent used.

The exemplary reaction described above is represented below in a reaction scheme:

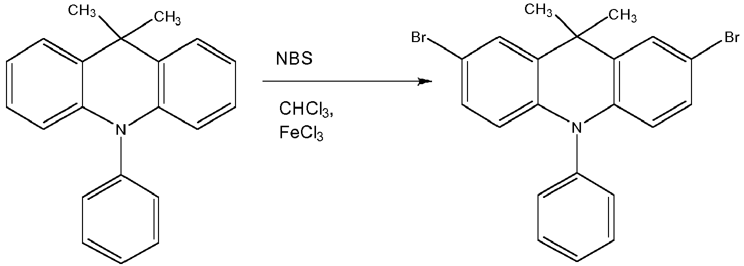

In the final reaction step, the acridine compounds of formula (1) are then obtained by substituting the bromine atoms at the phenyl rings of the acridine by R₂ respectively R₃. The respective substitution reactions suitable for this step have been described in the literature so that no further details need to be given here.

Just by way of example, the reaction conditions may be similar as in the first step, i.e. a catalyst system comprising Pd(dba)₂ and P(t-bu)₃ with a combination of toluene and NaOt-Bu may be used.

The molar ratio of the reactants in the various steps is chosen in accordance with the stoichiometry of the reaction. In the first step it has proved to be advantageous to use the brominating agent in a slight molar excess, e.g. 5 to 20 %, compared to the acridine derivative. The same applies to the second step.

The amount of catalyst is usually in the range of from 0.5 to 5 mol%, based on the brominating agent respectively starting material, but can be varied in accordance with the specific reaction carried out.

In the final step, the reactants are again basically used in stoichiometric amounts.

The acridine compounds used in the devices in accordance with the present invention usually have glass transition temperatures in the range of from 120 to 200°C, mostly in the range of from 130 to 180°C.

The devices in accordance with the present invention comprise the compounds of formula (1) in at least one emissive layer situated between the anode and the cathode. Within this layer, said compounds may be the only emitter or they may be used in combination with a conventional fluorescent emitter.

In accordance with another preferred embodiment of the present invention, the emitting layer is composed of a conventional host material and a combination of a compound of formula (1) described hereinbefore and a conventional fluorescence emitter not capable of emitting by delayed fluorescence which has been described in the literature. The TADF compound of formula (1) in such a system serves the function of an assistant dopant which may lead to an excitation spin factor of up to 100 % and thus significantly improve the external quantum efficiency of the device.

In such "double dopant" systems, the compound of formula (1) does not itself emit light but pases the generated excitons to the fluorescence emitter for radiative decay. To optimize the effect of the assistant dopant, a good overlap of the emission of the TADF compound of formula (1) and the acceptor (the emitter) absorption is advantageous.

If the compound of formula (1) is used as the emitter itself, it usually constitutes of from 1 to 10 % by weight of the emissive layer. If it is used as assistant dopant, the weight percentage may be higher and may be up to 50 % of the entire weight of the emissive layer, preferably of from 5 to 25 wt% of the emissive layer.

Host materials suitable for use in the emissive layer have been described in the literature and are known to the skilled person who will select the best suited host material depending on the specific application situation.

Just by way of example wide energy gap hosts such as mCP (1,3-Bis-(N-carbazolyl)benzene), mCBP (3,3-Di(9H-carbazol-9-yl)biphenyl), CBP (4,4'Bis(9-carbazolyl)-1,1'biphenyl) or DPEPO (Bis((2-(diphenylphosphino)phenyl))ether may be mentioned here.

The device in accordance with the present invention comprises at least an anode, a cathode ands one emissive layer as described hereinbefore.

As is well known for light emitting organic devices, it may provide advantages to provide additional layers which may be located between the anode and the emissive layer or the cathode and the emissive layer.

Additional layers which may be mentioned here are hole injection layers, hole transport layers, electron injection layers, electron transport layers, hole blocking layers and electron blocking layers.

A hole injection layer has the function of transporting holes form the anode to the side of the light emitting layer and has therefore preferably a good adhesion to the anode surface.

A hole transport layer serves the function of transporting holes to the emissive layer and is therefore composed of a material showing a good hole transport capability.

A hole blocking layer has the function of preventing the holes which have passed through the emissive layer from moving towards the cathode. and is thus preferably located between the emissive layer and the organic layer adhering to the cathode.

The electron injection layer has the function of transporting electrons to the side of the emissive layer and thus has preferably a good adherence to the cathode surface.

An electron transport layer has the function of transportinmg electrons to the emissive layer and thus has usually a good electron transport capability.

An electron blocking layer has the function of preventing the electrons which have passed through the emissive layer from moving towards the anode and is thus preferably located between the emissive layer and the organic layer adhering to the anode.

Suitable materials for any of the aformentioned layers which may optionally be present in the device in accordance with the present invention have been described in the literature in great variety and thus there is no need to give further details here.

There is in principle no specific limitation for the material of any of these layers and the skilled person can freely select from the known materials for the respective purpose.

The devices in accordance with the present invention show advantageous properties in terms of external quantum efficiencies and long term stability. Furthermore, since they are free of heavy metal compounds, the limitations of devices comprising such compounds can be overcome.

The compounds of formula (1) are generally useful for organic electronic devices, in particular organic light emitting devices like OLEDs which emit light through delayed fluorescence, in particular through thermally activated delayed fluorescence.

## Claims

1. Organic electronic device comprising an anode, a cathode and at least one emissive layer free of compounds of heavy atoms having an atomic number exceeding 40 comprising a compound of formula (1) 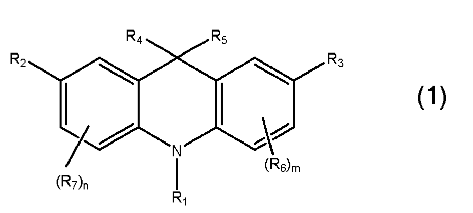 wherein R₁, is hydrogen, a C₁-C₁₈ alkyl group, a C₅-C₃₀ aryl group or a C₄-C₃₀ heteroaryl group,
R₂ and R₃, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence, are a C₁-C₁₈ alkyl group, a C₅-C₃₀ aryl group or a C₄-C₃₀ heteroaryl group, which may form together a condensed ring system,
R₄ and R₅, which may be the same or different at each occurrence, are hydrogen, a C₁-C₁₈ alkyl group, a C₅-C₃₀ aryl group or a C₄-C₃₀ heteroaryl group, or R₄ and R₅ may form together a substituted or unsubstituted C₅-C₄₀ hydrocarbyl or C₃-C₄₀ heterohydrocarbyl ring system with the exception of a fluorenyl ring system, and
R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4),
and m and n, which may be the same or different, represent an integer of from 0 to 3.

2. Organic electronic device in accordance with claim 1 wherein the compounds of formula (1) have an energy gap ΔEₛₜ between the excited singlet state S1 and the excited triplet state T1 of at most 0.5 eV.

3. Organic electronic device in accordance with any of claims 1 or 2 wherein at least one of R₁, R₂, R₃, R₆ or R₇ is an electron withdrawing group.

4. Organic electronic device in accordance with claim 3 wherein the electron withdrawing group has a value for σp in the Hammett equation of at least 0.02.

5. Organic electronic device in accordance with claim 3 or 4 wherein the electron withdrawing group is selected from nitro, cyano, halogen, perfluoroalkyl groups, sulfonyl, oxadiazolyl, benzothiadiazoly, tetrazolyl, thiazolyl or imidazolyl, phosphine-oxide structures comprising groups or aromatic groups bearing halogen or cyano substituents.

6. Organic electronic device in accordance with any of claims 1 to 5 wherein at least one of R₂ and R₃ represents a group of formula 2 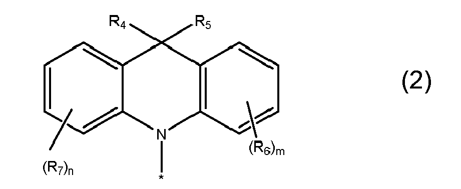 wherein R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4),
and m and n, which may be the same or different, represent an integer of from 0 to 3.

7. Organic electronic device in accordance with any of claims 1 to 5 wherein at least one of R₂ and R₃ represents a group of formula (4) 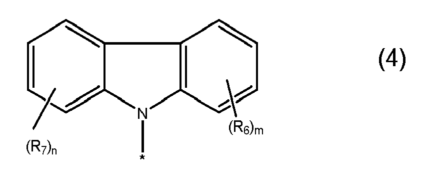 wherein R₆ and R₇, which may be the same or different at each occurrence, are a C₁-C₁₈ alkyl group, a C₅-C₃₀ aryl group or a C₄-C₃₀ heteroaryl group or a group NR₈R₉ wherein R₈ and R₉, which may be the same or different at each occurrence are a C₁-C₁₈ alkyl group, a C₅-C₃₀ aryl group or a C₄-C₃₀ heteroaryl group or wherein NR₈R₉ is represented by formula (4),
and m and n, which may be the same or different, represent an integer of from 0 to 3.

8. Organic electronic device in accordance with any of claims 1 to 7 comprising at least one additional layer selected from hole injection layers, hole transport layers, electron injection layers, electron transport layers, hole blocking layers and electron blocking layers.

9. Organic electronic device in accordance with any of claim 9 wherein the emissive layer is composed of a host material and a combination of a compound of formula (1) and a conventional fluorescent emitter not capable of emitting by delayed fluorescence.

10. Organic electronic device in accordance with claim 1 which is an organic light emitting diode (OLED).

11. Use of the compounds of formula (1) as defined in claim (1) in organic electronic devices emitting light through delayed fluorescence.

12. Use in accordance with claim 11 as assistant dopant in the emissive layer of the organic electronic device.
